# EUROPÄISCHE PATENTSCHRIFT

(11) **EP 1 340 316 B1**
(45) Veröffentlichungstag und Bekanntmachung des Hinweises auf die Patenterteilung: **21.02.2007**
(21) Anmeldenummer: 01997891.5
(22) Anmeldetag: 06.11.2001
(51) Int. Cl.: H03H 9/58

(54) **BULK-ACOUSTIC-WAVE-FILTER**
BULK ACOUSTIC WAVE FILTER
FILTRE D'ONDES ACOUSTIQUES EN VOLUME

(30) Priorität: 24.11.2000 DE 10058339
(43) Veröffentlichungstag der Anmeldung: 03.09.2003
(73) Patentinhaber: Infineon Technologies AG, 81669 München (DE)
(72) Erfinder: AIGNER, Robert, 81675 München (DE); MARKSTEINER, Stephan, 85640 Putzbrunn (DE); NESSLER, Winfried, 81739 München (DE); ELBRECHT, Lüder, 81825 München (DE)
(74) Vertreter: Ginzel, Christian
(86) Internationale Anmeldenummer: PCT/EP2001/012825
(87) Internationale Veröffentlichungsnummer: WO 2002/043243

(56) Entgegenhaltungen:
- EP-A- 0 880 227
- EP-A- 1 170 862
- US-A- 4 317 093
- US-A- 5 572 173
- US-A- 5 939 957

## Beschreibung

Die Erfindung betrifft Bulk-Acoustic-Wave-Filter.

Elektrische Filter, die aus Bulk-Acoustic-Wave-Resonatoren oder Stacked-Crystal-Filter aufgebaut sind, werden üblicherweise als Bulk-Acoustic-Wave-Filter bezeichnet.

Bulk-Acoustic-Wave-Resonatoren bestehen typischerweise aus zwei Elektroden und einer piezoelektrischen Schicht, die zwischen den beiden Elektroden angeordnet ist. Ein solcher Stapel aus Elektrode 1 / Piezoschicht / Elektrode 2 wird auf einem Träger angeordnet, der die akustische Welle reflektiert (M. Kenneth, G. R. Kline, K. T. McCarron, High-Q Microwave Acoustic Resonatores and Filters, IEEE Transactions on Microwave Theory and Techniques, Vol. 41, No. 12, 1993).

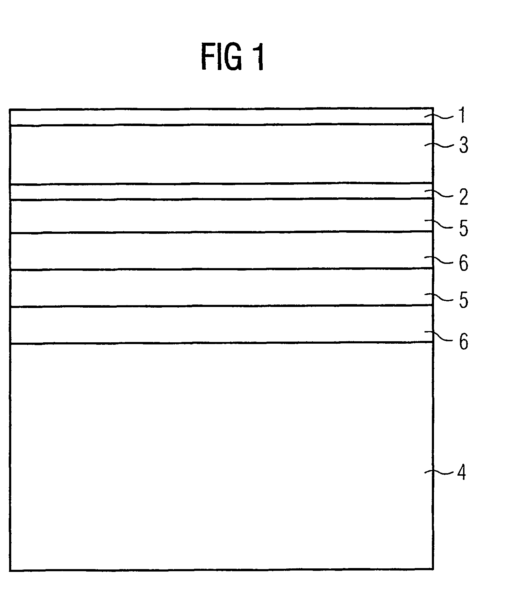

Die Fig. 1 zeigt einen Querschnitt durch einen Bulk-Acoustic-Wave-Resonator. Grundsätzlich wäre die Verwendung einer Konfiguration ausschließlich bestehend aus Elektrode 1 / Piezoschicht 3 / Elektrode 2 erstrebenswert. Allerdings weist eine solche Anordnung eine zu geringe Stabilität auf. Daher wird die Anordnung auf ein Substrat 4 aufgebracht, was aber mit dem Nachteil verbunden ist, dass die Schallwellen in das Substrat 4 eindringen und dadurch Störungen verursacht werden. Das Substrat 4 sollte also neben einer mechanischen Trägerfunktion gleichzeitig eine möglichst gute akustische Isolation bereitstellen. Die Figur 1 zeigt einen akustischen Spiegel, der aus einem Substrat 4 und einer Abfolge von zwei low-Z- 5 und zwei high-Z- 6 Schichten besteht.

Stacked-Crystal-Filter bestehen im allgemeinen aus zwei piezoelektrischen Schichten und drei Elektroden. Diese insgesamt fünf Elemente bilden eine Sandwich-Struktur, wobei jeweils eine piezoelektrische Schicht zwischen zwei Elektroden angeordnet ist. Die mittlere der drei Elektroden wird dabei in der Regel als Erdungselektrode verwendet.

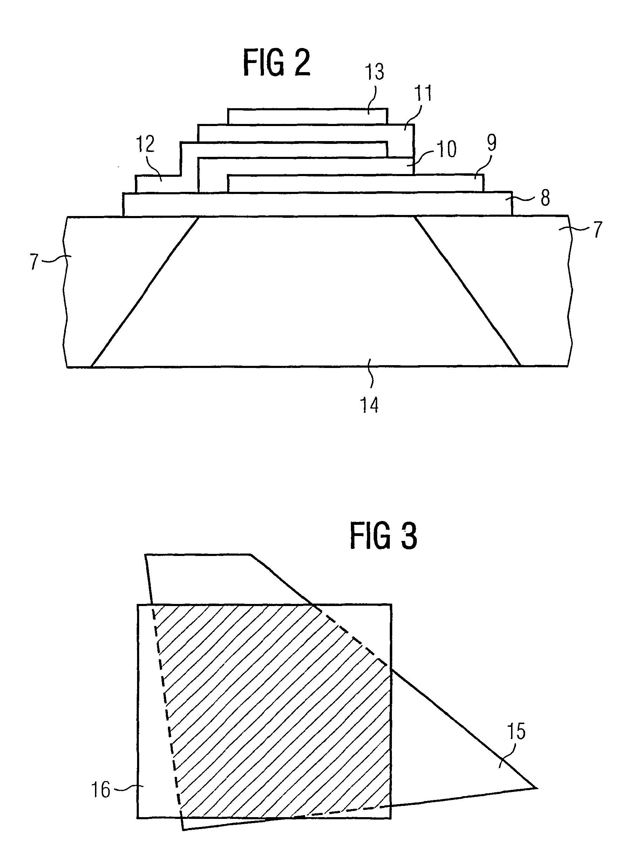

Die Figur 2 zeigt einen Querschnitt durch einen Stacked-Crystal-Filter. Der Stacked-Crystal-Filter besteht aus einem Substrat 7, einer Membran 8, einer ersten, unteren Elektrode 9, einer ersten, unteren piezoelektrischen Schicht 10, einer zweiten, oberen piezoelektrischen Schicht 11, einer zweiten mittleren Elektrode 12 und einer dritten, oberen Elektrode 13. Die mittlere Elektrode 12 ist über einem Teil der unteren piezoelektrischen Schicht 10 und der Membran 8 angeordnet, die obere piezoelektrische Schicht 11 ist über Teilen der mittleren Elektrode 12 und der unteren piezoelektrischen Schicht 10 angeordnet und die dritte, obere Elektrode 13 ist über der oberen piezoelektrischen Schicht 11 angeordnet. Die zweite Elektrode 12 dient als Erdungselektrode. Das Substrat 7 weist einen Hohlraum 14 auf, der dazu dient, die akustischen Schwingungen der piezoelektrischen Schichten zu reflektieren.

Die Reflexion der akustischen Schwingungen wird somit entweder mit Hilfe eines akustischen Spiegels oder mit Hilfe eines Hohlraums erreicht. Ein akustischer Spiegel wurde oben im Zusammenhang mit einem Bulk-Acoustic-Wave-Resonator beschrieben, während die Reflexion der akustischen Schwingungen durch einen Hohlraum für einen Stacked-Crystal-Filter gezeigt wurde. Selbstverständlich ist aber auch die umgekehrte Kombination möglich, also ein Bulk-Acoustic-Wave-Resonator mit einem Hohlraum im Substrat genauso wie ein Stacked-Crystal-Filter mit einem akustischen Spiegel.

Die piezoelektrischen Schichten sind in der Regel aus Aluminiumnitrid aufgebaut. Als Material für die Elektroden werden häufig Aluminium, Aluminium-enthaltende Legierungen, Wolfram, Molybdän oder Platin verwendet. Als Substratmaterial kann z.B. Silizium, Galliumarsenid, Glas oder eine Folie verwendet werden.

Wie oben bereits erläutert weist jeder Bulk-Acoustic-Wave-Resonator oder Stacked-Crystal-Filter wenigstens zwei Elektroden auf. Die Figur 3 zeigt eine Aufsicht auf zwei übereinander gelagerte Elektroden, nämlich eine untere Elektrode 15 und eine obere Elektrode 16. Die beiden Elektroden können jede beliebige geometrische Form aufweisen. Als "effektive Resonatorfläche" wird im Rahmen der vorliegenden Erfindung die Fläche der Elektroden bezeichnet, die sich bei einer Projektion der beiden Elektroden in eine Ebene als der überlappende Bereich der Elektroden ergibt. Die effektive Resonatorfläche der Elektroden 15 und 16 ist in Fig. 3 schraffiert dargestellt. Aufgrund der grundsätzlich beliebigen Form der Elektroden 15 und 16 ergibt sich für die effektive Resonatorfläche eine beliebig geformte ebene Fläche.

Jeder Bulk-Acoustic-Wave-Resonator weist somit eine bestimmte effektive Resonatorfläche auf, die durch ihre geometrische Form und durch ihren Flächeninhalt gekennzeichnet ist. Zwei Bulk-Acoustic-Wave-Resonatoren mit unterschiedlicher effektiver Resonatorfläche können sich also grundsätzlich in der Flächenform der effektiven Resonatorfläche und/oder im Flächeninhalt der effektiven Resonatorfläche unterscheiden.

Ein Bulk-Acoustic-Wave-Filter setzt sich aus einer Mehrzahl von parallel bzw. in Reihe geschalteten Bulk-Acoustic-Wave-Resonatoren oder Stacked-Crystal-Filter zusammen. Im folgenden wird der Begriff "Bulk-Acoustic-Wave-Resonator" synonym für die beiden, in den Figuren 1 und 2 gezeigten, Vorrichtungen, nämlich Bulk-Acoustic-Wave-Resonator und Stacked-Crystal-Filter, gebraucht.

Das Design der Bulk-Acoustic-Wave-Filter wird in der Regel derart gestaltet, dass die in Serie geschalteten Resonatoren eine serielle Resonanz aufweisen, deren Frequenz möglichst genau der gewünschten Frequenz des Filters entspricht, während entsprechend die parallel geschalteten Resonatoren eine parallele Resonanz aufweisen, deren Frequenz ebenfalls möglichst genau der gewünschten Frequenz des Filters entspricht.

Eine besondere Problematik bei der Verwendung von Bulk-Acoustic-Wave-Filtern stellen die Störmoden der Bulk-Acoustic-Wave-Resonatoren, aus denen die Filter aufgebaut sind, dar. Diese Störmoden führen zu Störspitzen in der elektrischen Impedanzkurve der Bulk-Acoustic-Wave-Resonatoren, die sich in weiterer Folge auch auf den Durchlassbereich der Filter nachteilig auswirkt. Vor allem wird das Stehwellenverhältnis verschlechtert bzw. die Phasenkurve der Filter verzerrt, wodurch z.B. in Receiver-Frontends die Bedingung konstanter Gruppenlaufzeit innerhalb eines Sendekanals verletzt wird.

Aus dem Stand der Technik sind verschiedene Ansätze bekannt, mit denen eine Unterdrückung der Störmoden versucht wird. Die US 5,903,087 offenbart Bulk-Acoustic-Wave-Resonatoren, deren Elektroden an den Rändern nicht geglättet sind, sondern vielmehr in Form eines Zufallsmusters angerauhte Ränder aufweisen, wobei die Rauhigkeit ungefähr die Dimension der Wellenlängen der Störmoden aufweist. Die Störmoden werden dadurch unterdrückt und sind in der Impedanzkurve weniger sichtbar. Allerdings treten bei diesem Verfahren starke Energieverluste auf, die sich auf die Güte der Hauptresonanzen auswirken.

Die EP 1 170 862 beschreibt ein Bulk-Acoustic-Wave-Filter in einer Leiteranordnung, bei dem mehrere kreisförmige Bulk-Acoustic-Wave-Resonatoren unterschiedlicher Resonatorfläche verwendet werden.

Die EP 0 880 227 beschreibt ein Bulk-Acoustic-Wave-Filter in einer Leiteranordnung, bei dem mehrere quadratische Bulk-Acoustic-Wave-Resonatoren unterschiedlicher Resonatorfläche verwendet werden.

Die US 5,939,957 beschreibt ein Bulk-Acoustic-Wave-Filter in einer Leiteranordnung, bei dem mehrere rechteckige Bulk-Acoustic-Wave-Resonatoren unterschiedlicher Resonatorfläche verwendet werden.

Der vorliegenden Erfindung liegt daher die Aufgabe zugrunde, Bulk-Acoustic-Wave-Filter zur Verfügung zu stellen, bei denen die Störmoden gedämpft werden, aber gleichzeitig die Nutzresonanz nur unwesentlich oder überhaupt nicht beeinflusst wird.

Diese Aufgabe wird durch den Bulk-Acoustic-Wave-Filter gemäß unabhängigem Patentanspruch 1 gelöst. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

Der erfindungsgemäße Bulk-Acoustic-Wave-Filter umfasst wenigstens zwei Bulk-Acoustic-Wave-Resonatoren, wobei jeder Bulk-Acoustic-Wave-Resonator wenigstens eine erste Elektrode, eine piezoelektrische Schicht und eine zweite Elektrode umfasst. Wenigstens zwei der Bulk-Acoustic-Wave-Resonatoren weisen effektive Resonatorflächen auf, die sich in Flächenform und/oder Flächeninhalt unterscheiden. Durch diese Gestaltung der Bulk-Acoustic-Wave-Resonatoren lassen sich Störmoden optimal unterdrücken, ohne dass dabei das Impedanzniveau des Filter beeinflusst wird.

Da jeder Resonator andere Störmodenfrequenzen aufweist, kommt es durch die Verschaltung im Filter zu einem Mittelungseffekt. Dadurch macht sich die einzelne Störmode im Filterresponse im Vergleich zu den aus dem Stand der Technik bekannten Bulk-Acoustic-Wave-Filtern mit Resonatoren gleicher Fläche nicht so stark bemerkbar. Allerdings beeinflussen unterschiedliche Flächeninhalte der effektiven Resonatorflächen auch das Impedanzniveau der Resonatoren. Sie sind daher durch Impedanzanpassbedingungen im Filter in einem gewissen Rahmen festgelegt.

Sämtliche Ausführungsformen der vorliegenden Erfindung beruhen also darauf, dass nicht versucht wird, den einzelnen Bulk-Acoustic-Wave-Resonator störmodenfrei zu machen, was technisch schwierig ist und möglicherweise Resonator-Perfomance kostet, sondern darauf, dass erst mit der Verschaltung im Filter eine Verwaschung von vielen Störmoden bei unterschiedlichen Frequenzen eintritt und damit die Transmissionsfunktion des Filters den erwünschten glatten Verlauf erhält.

Gemäß einer bevorzugten Ausführungsform der vorliegenden Erfindung weisen alle Bulk-Acoustic-Wave-Resonatoren des Bulk-Acoustic-Wave-Filters effektive Resonatorflächen auf, die sich in Flächenform und/oder Flächeninhalt unterscheiden. Dadurch können Störmoden noch stärker unterdrückt werden.

Gemäß einer bevorzugten Ausführungsform der vorliegenden Erfindung weisen wenigstens zwei der Bulk-Acoustic-Wave-Resonatoren eine effektive Resonatorfläche mit unterschiedlichem Aspektverhältnis auf. Das Aspektverhältnis beeinflusst die Lage der Störmoden in ähnlicher Weise wie sie durch den Flächeninhalt der effektiven Resonatorflächen der Bulk-Acoustic-Wave-Resonatoren beeinflusst wird, verändert aber das Impedanzniveau nicht. Die Störmoden werden somit wirkungsvoll unterdrückt, wobei gleichzeitig die Nutzresonanz unverändert bleibt.

Besonders bevorzugt wird eine Ausführungsform, bei der alle Bulk-Acoustic-Wave-Resonatoren effektive Resonatorflächen mit unterschiedlichen Aspekt-Verhältnissen aufweisen. Dadurch können Störmoden noch stärker unterdrückt werden.

Ebenfalls bevorzugt wird eine Ausführungsform der vorliegenden Erfindung gemäß der wenigstens zwei der Bulk-Acoustic-Wave-Resonatoren effektive Resonatorflächen mit einer nicht-rechtwinkligen Form aufweisen. Unter einer nicht-rechtwinkligen Form der effektiven Resonatorfläche eines Bulk-Acoustic-Wave-Resonators wird eine Form verstanden, bei der die Winkel zwischen den Begrenzungslinien der effektiven Resonatorfläche ungleich 90° sind. Durch diese Ausgestaltung der Resonatoren gelingt eine gute unterdrückung der Störmoden.

Besonders bevorzugt wird eine Ausführungsform, bei der alle Bulk-Acoustic-Wave-Resonatoren effektive Resonatorflächen mit einer nicht-rechtwinkligen Form aufweisen. Dadurch können Störmoden noch stärker unterdrückt werden.

Beste Resultate lassen sich mit Bulk-Acoustic-Wave-Filtern erzielen, bei denen wenigstens zwei der Bulk-Acoustic-Wave-Resonatoren effektive Resonatorflächen mit unterschiedlichem Flächeninhalt und gleichzeitig unterschiedlichem Aspektverhältnis aufweisen. Durch passende Wahl des Flächeninhalts der effektiven Resonatorfläche und gleichzeitige Variation des Aspektverhältnisses der effektiven Resonatorfläche lassen sich sowohl Impedanzanpassungsbedingungen erfüllen als auch Störmoden optimal unterdrücken.

Eine weitere Verbesserung wird mit Ausführungsformen erzielt, bei denen alle Bulk-Acoustic-Wave-Resonatoren effektive Resonatorflächen mit unterschiedlichen Flächeninhalten und unterschiedlichen Aspektverhältnissen aufweisen. Dadurch können Störmoden noch stärker unterdrückt werden.

Ebenfalls bevorzugt werden Bulk-Acoustic-Wave-Filter, wobei wenigstens zwei der Bulk-Acoustic-Wave-Resonatoren eine effektive Resonatorfläche mit unterschiedlichem Aspektverhältnis und gleichzeitig nicht-rechtwinkliger Form aufweisen.

Besonders bevorzugt werden Ausführungsformen, bei denen alle Bulk-Acoustic-Wave-Resonatoren effektive Resonatorflächen mit unterschiedlichen Aspektverhältnissen und nicht-rechtwinkliger Form aufweisen. Dadurch können Störmoden noch stärker unterdrückt werden.

Besonders bevorzugt werden Ausführungsformen der vorliegenden Erfindung, gemäß denen wenigstens zwei Bulk-Acoustic-Wave-Resonatoren eines Bulk-Acoustic-Wave-Filters eine effektive Resonatorfläche mit unterschiedlichem Flächeninhalt, unterschiedlichen Aspektverhältnis und nicht-rechtwinkliger Form aufweisen.

Ebenfalls besonders bevorzugt werden Ausführungsformen, bei denen alle Bulk-Acoustic-Wave-Resonatoren effektive Resonatorflächen mit unterschiedlichen Flächeninhalten, unterschiedlichen Aspektverhältnissen und nicht-rechtwinkliger Form aufweisen. Dadurch können Störmoden noch stärker unterdrückt werden.

Besonders gute Störmodenunterdrückung wird erreicht, wenn das Aspektverhältnis der effektiven Resonatorflächen der erfindungsgemäßen Bulk-Acoustic-Wave-Resonatoren zwischen 1:1 und 1:5 liegt, insbesondere zwischen 1:1.5 und 1:3.

Weisen die effektiven Resonatorflächen der Bulk-Acoustic-Wave-Resonatoren unterschiedlichen Flächeninhalt auf, so wird bevorzugt, dass sich der Flächeninhalt der effektiven Resonatorflächen um wenigstens 5 % voneinander unterscheidet, insbesondere um wenigstens 10 %. Ganz besonders bevorzugt wird, dass sich der Flächeninhalt der effektiven Resonatorflächen um wenigstens 20 % voneinander unterscheidet, insbesondere um wenigstens 50 %.

Die Bulk-Acoustic-Wave-Filter werden durch Verschaltung von Bulk-Acoustic-Wave-Resonatoren hergestellt. Das Prinzip, den Flächeninhalt der effektiven Resonatorfläche, das Aspektverhältnis der effektiven Resonatorfläche und/oder den Winkel zwischen den Begrenzungslinien der effektiven Resonatorflächen zu variieren, um Störmoden im Filterresponse zu unterdrücken, lässt sich auf jede Filtertopologie anwenden. Gemäß besonders bevorzugten Ausführungsformen der vorliegenden Erfindung erfolgt die Verschaltung in Form eines 1½-stufigen Leiterfilters, in Form eines 2-stufigen Leiterfilters, in Form eines 2½-stufigen Leiterfilters, in Form eines 3-stufigen Leiterfilters oder in Form eines 3½-stufigen Leiterfilters, wobei 3, 4, 5, 6 oder 7 Bulk-Acoustic-Wave-Resonatoren verschaltet werden.

Ebenfalls bevorzugt wird die Verschaltung der Bulk-Acoustic-Wave-Resonatoren zu einem Bulk-Acoustic-Wave-Filter in Form eines 1-stufigen balanced Filters, in Form eines 2-stufigen balanced Filters oder in Form eines 3-stufigen balanced Filters. Es werden in diesem Fall 4, 8 oder 12 Bulk-Acoustic-Wave-Resonatoren verschaltet.

Die Erfindung wird nachfolgend anhand der Figuren 1 bis 8 näher dargestellt. Es zeigen:
- Fig. 1: einen aus dem Stand der Technik bekannten Bulk-Acoustic-Wave-Resonator;
- Fig. 2: einen aus dem Stand der Technik bekannten Stacked-Crystal-Filter;
- Fig. 3: zwei übereinandergelagerte Elektroden und deren effektive Resonatorfläche;
- Fig. 4: einen aus dem Stand der Technik bekannten 2-stufigen Leiterfilter;
- Fig. 5: einen erfindungsgemäßen 2-stufigen Leiterfilter aufgebaut aus Bulk-Acoustic-Wave-Resonatoren mit unterschiedlichem Flächeninhalt der effektiven Resonatorflächen;
- Fig. 6: einen erfindungsgemäßen 2-stufigen Leiterfilter aufgebaut aus Bulk-Acoustic-Wave-Resonatoren mit unterschiedlichem Aspektverhältnis der effektiven Resonatorflächen;
- Fig. 7: Auftragung (schematisch) des Streuparameters von Eingang zu Ausgang (S₁₂) gegen die Frequenz für einen 3-stufigen Leiterfilter mit 6 identischen quadratischen Einzelresonatoren (Stand der Technik);
- Fig. 8: Auftragung (schematisch) des Streuparameters von Eingang zu Ausgang (S₁₂) gegen die Frequenz für einen 3-stufigen Leiterfilter mit 6 Einzelresonatoren mit unterschiedlichen Aspektverhältnissen der effektiven Resonatorflächen (Erfindung).

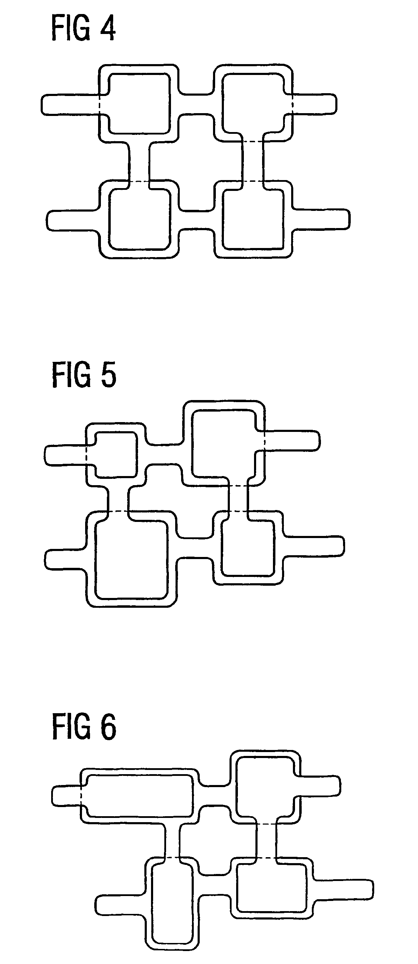

Fig. 4 zeigt einen aus dem Stand der Technik bekannten 2-stufigen Leiterfilter mit 4 gleich großen quadratischen Bulk-Acoustic-Wave-Resonatoren, die eine identische effektive Resonatorfläche aufweisen. Die Störmoden jedes Einzelresonators treten an den gleichen Frequenzstellen auf und sind entsprechend im elektrischen Response des Filters zu finden.

Fig. 5 zeigt einen 2-stufigen Leiterfilter mit 4 Bulk-Acoustic-Wave-Resonatoren mit effektiven Resonatorflächen, die unterschiedliche Flächeninhalte aufweisen. Jeder Resonator hat unterschiedliche Störmodenfrequenzen. Durch die Verschaltung im Filter kommt es zu einem Mittelungseffekt, wodurch sich die einzelne Störmode im Filterresponse im Vergleich zu der in Fig. 4 gezeigten Ausführungform des Standes der Technik nicht so stark bemerkbar macht.

Fig. 6 zeigt einen 2-stufigen Leiterfilter mit 4 Bulk-Acoustic-Wave-Resonatoren mit effektiven Resonatorflächen, die zwar gleichen Flächeninhalt, aber unterschiedliche Aspektverhältnisse aufweisen. Das Aspektverhältnis beeinflusst die Lage der Störmoden in ähnlicher Weise wie bei der in Fig. 5 gezeigten Ausführungsform, wobei aber gleichzeitig das Impedanzniveau des Filters unverändert bleibt.

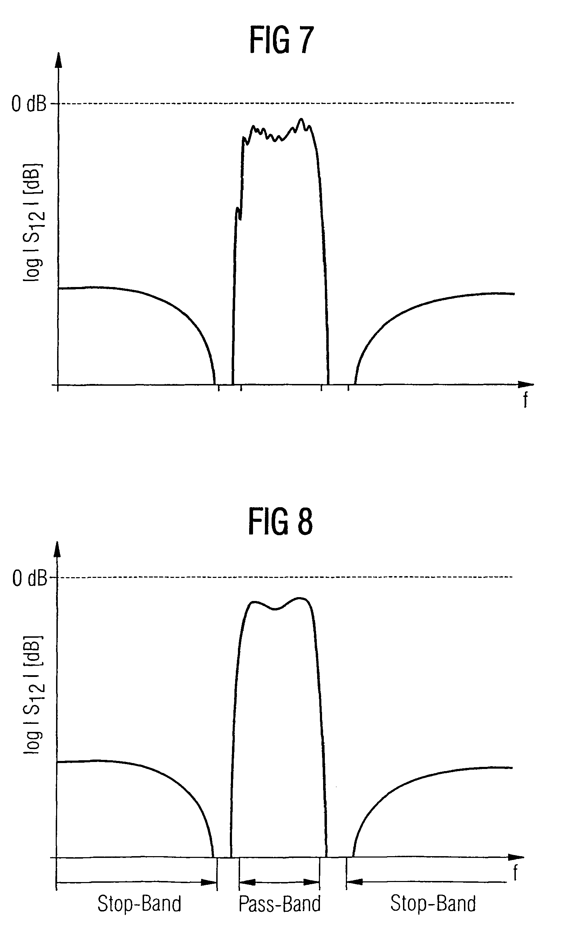

Die Figuren 7 und 8 zeigen jeweils eine schematische Auftragung des Streuparameters von Eingang zu Ausgang S₁₂ in logarithmischer Skala gegen die Frequenz für einen 3-stufigen Leiterfilter mit 6 Einzelresonatoren. Zur Bestimmung von S₁₂ wurde in bekannter Weise durch einen Frequenzanalysator die Streumatrix des Leiterfilters ermittelt.

In der Fig. 7 ist die Kennlinie eines aus dem Stand der Technik bekannten Leiterfilters, der aus 6 gleichen quadratischen Einzelresonatoren mit identischen effektiven Resonatorflächen besteht, dargestellt. Die Kennlinie zeigt ein "Rauschen" im Passband, das von spurious modes der Einzelresonatoren verursacht ist.

In der Fig. 8 ist die Kennlinie eines Leiterfilters gemäß der vorliegenden Erfindung dargestellt, der die gleiche Topologie aufweist wie der Leiterfilter, dessen Kennlinie in Fig. 7 dargestellt ist, allerdings weisen die effektiven Resonatorflächen der 6 Einzelresonatoren unterschiedliche Aspektverhältnisse auf. Das Rauschen im Passband mittelt sich aus der Kurve heraus, da die spurious modes der Einzelresonatoren an verschiedenen Frequenzpunkten auftreten.

Ähnliche Ergebnisse liefert ein Vergleich von einerseits Filtern mit Einzelresonatoren mit quadratischen effektiven Resonatorflächen und andererseits Filtern, bei denen die effektiven Resonatorflächen der Einzelresonatoren nicht rechtwinklige Form aufweisen (Winkel zwischen den Begrenzungslinien der effektiven Resonatorflächen der Einzelresonatoren ungleich 90°). Hier wird ein deutlich geringeres Rauschen im Passband für den Filter festgestellt, dessen Einzelresonatoren effektive Resonatorflächen mit nicht-rechtwinkliger Form aufweisen.

## Patentansprüche (Patentansprüche für folgende(n) Vertragsstaat(en): IT)

1. Bulk-Acoustic-Wave-Filter umfassend wenigstens zwei Bulk-Acoustic-Wave-Resonatoren, wobei jeder Bulk-Acoustic-Wave-Resonator wenigstens eine erste Elektrode (2; 9), eine piezoelektrische Schicht (3; 10, 11) und eine zweite Elektrode (1; 12, 13) umfasst, wobei die erste Elektrode (2; 9) auf einem Substrat (4; 7) angeordnet ist,
**dadurch gekennzeichnet, dass**
wenigstens zwei der Bulk-Acoustic-Wave-Resonatoren effektive Resonatorflächen aufweisen, die sich in Flächenform und/oder Flächeninhalt unterscheiden, wobei die effektiven Resonatorflächen, die sich jeweils bei einer Projektion der beiden Elektroden (15, 16) eines Bulk-Acoustic-Wave Resonators in eine Ebene als der überlappende Bereich der Elektroden ergeben, von wenigstens zwei der Bulk-Acoustic-Wave-Resonatoren eine nicht-rechtwinklige Form aufweisen.

2. Bulk-Acoustic-Wave-Filter nach Anspruch 1,
**dadurch gekennzeichnet, dass**
alle Bulk-Acoustic-Wave-Resonatoren effektive Resonatorflächen aufweisen, die sich in Flächenform und/oder Flächeninhalt unterscheiden.

3. Bulk-Acoustic-Wave-Filter nach Anspruch 1 oder 2,
**dadurch gekennzeichnet, dass**
die effektiven Resonatorflächen von wenigstens zwei der Bulk-Acoustic-Wave-Resonatoren ein unterschiedliches Aspektverhältnis aufweisen.

4. Bulk-Acoustic-Wave-Filter nach Anspruch 3,
**dadurch gekennzeichnet, dass**
die effektiven Resonatorflächen aller Bulk-Acoustic-Wave-Resonatoren unterschiedliche Aspektverhältnisse aufweisen.

5. Bulk-Acoustic-Wave-Filter nach Anspruch 1,
**dadurch gekennzeichnet, dass**
die effektiven Resonatorflächen aller Bulk-Acoustic-Wave-Resonatoren eine nicht-rechtwinklige Form aufweisen.

6. Bulk-Acoustic-Wave-Filter nach einem der Ansprüche 3 bis 5,
**dadurch gekennzeichnet, dass**
das Aspekt-Verhältnis der effektiven Resonatorflächen zwischen 1:1 und 1:5 liegt.

7. Bulk-Acoustic-Wave-Filter nach Anspruch 6,
**dadurch gekennzeichnet, dass**
das Aspekt-Verhältnis der effektiven Resonatorflächen zwischen 1:1.5 und 1:3 liegt.

8. Bulk-Acoustic-Wave-Filter nach einem der vorhergehenden Ansprüche,
**dadurch gekennzeichnet, dass**
sich der Flächeninhalt der effektiven Resonatorflächen um wenigstens 5 % voneinander unterscheidet, insbesondere um wenigstens 10 %.

9. Bulk-Acoustic-Wave-Filter Anspruch 8,
**dadurch gekennzeichnet, dass**
sich der Flächeninhalt der effektiven Resonatorflächen um wenigstens 20 % voneinander unterscheidet, insbesondere um wenigstens 50 %.

10. Bulk-Acoustic-Wave-Filter nach einem der vorhergehenden Ansprüche,
**dadurch gekennzeichnet, dass**
die Bulk-Acoustic-Wave-Resonatoren in Form eines 1½-stufigen Leiterfilters, in Form eines 2-stufigen Leiterfilters, in Form eines 2½-stufigen Leiterfilters, in Form eines 3-stufigen Leiterfilters oder in Form eines 3½-stufigen Leiterfilters verschaltet sind.

11. Bulk-Acoustic-Wave-Filter nach einem der Ansprüche 1 bis 9,
**dadurch gekennzeichnet, dass**
die Bulk-Acoustic-Wave-Resonatoren in Form eines 1-stufigen balanced Filters, in Form eines 2-stufigen balanced Filters oder in Form eines 3-stufigen balanced Filters verschaltet sind.

## Patentansprüche (Patentansprüche für folgende(n) Vertragsstaat(en): DE, FR)

1. Bulk-Acoustic-Wave-Filter umfassend wenigstens zwei Bulk-Acoustic-Wave-Resonatoren, wobei jeder Bulk-Acoustic-Wave-Resonator wenigstens eine erste Elektrode (2; 9), eine piezoelektrische Schicht (3; 10, 11) und eine zweite Elektrode (1; 12, 13) umfasst, wobei die erste Elektrode (2; 9) auf einem Substrat (4; 7) angeordnet ist,
**dadurch gekennzeichnet, dass**
wenigstens zwei der Bulk-Acoustic-Wave-Resonatoren effektive Resonatorflächen aufweisen, die sich in Flächenform und Flächeninhalt unterscheiden, wobei die effektiven Resonatorflächen, die sich jeweils bei einer Projektion der beiden Elektroden (15, 16) eines Bulk-Acoustic-Wave Resonators in eine Ebene als der überlappende Bereich der Elektroden ergeben, von wenigstens zwei der Bulk-Acoustic-Wave-Resonatoren eine nicht-rechtwinklige Form aufweisen.

2. Bulk-Acoustic-Wave-Filter nach Anspruch 1,
**dadurch gekennzeichnet, dass**
alle Bulk-Acoustic-Wave-Resonatoren effektive Resonatorflächen aufweisen, die sich in Flächenform und/oder Flächeninhalt unterscheiden.

3. Bulk-Acoustic-Wave-Filter nach Anspruch 1 oder 2,
**dadurch gekennzeichnet, dass**
die effektiven Resonatorflächen von wenigstens zwei der Bulk-Acoustic-Wave-Resonatoren ein unterschiedliches Aspektverhältnis aufweisen.

4. Bulk-Acoustic-Wave-Filter nach Anspruch 3,
**dadurch gekennzeichnet, dass**
die effektiven Resonatorflächen aller Bulk-Acoustic-Wave-Resonatoren unterschiedliche Aspektverhältnisse aufweisen.

5. Bulk-Acoustic-Wave-Filter nach Anspruch 1,
**dadurch gekennzeichnet, dass**
die effektiven Resonatorflächen aller Bulk-Acoustic-Wave-Resonatoren eine nicht-rechtwinklige Form aufweisen.

6. Bulk-Acoustic-Wave-Filter nach einem der Ansprüche 3 bis 5,
**dadurch gekennzeichnet, dass**
das Aspekt-Verhältnis der effektiven Resonatorflächen zwischen 1:1 und 1:5 liegt.

7. Bulk-Acoustic-Wave-Filter nach Anspruch 6,
**dadurch gekennzeichnet, dass**
das Aspekt-Verhältnis der effektiven Resonatorflächen zwischen 1:1.5 und 1:3 liegt.

8. Bulk-Acoustic-Wave-Filter nach einem der vorhergehenden Ansprüche,
**dadurch gekennzeichnet, dass**
sich der Flächeninhalt der effektiven Resonatorflächen um wenigstens 5 % voneinander unterscheidet, insbesondere um wenigstens 10 %.

9. Bulk-Acoustic-Wave-Filter Anspruch 8,
**dadurch gekennzeichnet, dass**
sich der Flächeninhalt der effektiven Resonatorflächen um wenigstens 20 % voneinander unterscheidet, insbesondere um wenigstens 50 %.

10. Bulk-Acoustic-Wave-Filter nach einem der vorhergehenden Ansprüche,
**dadurch gekennzeichnet, dass**
die Bulk-Acoustic-Wave-Resonatoren in Form eines 1½-stufigen Leiterfilters, in Form eines 2-stufigen Leiterfilters, in Form eines 2½-stufigen Leiterfilters, in Form eines 3-stufigen Leiterfilters oder in Form eines 3½-stufigen Leiterfilters verschaltet sind.

11. Bulk-Acoustic-Wave-Filter nach einem der Ansprüche 1 bis 9,
**dadurch gekennzeichnet, dass**
die Bulk-Acoustic-Wave-Resonatoren in Form eines 1-stufigen balanced Filters, in Form eines 2-stufigen balanced Filters oder in Form eines 3-stufigen balanced Filters verschaltet sind.

## Claims (Claims for the following Contracting State(s): IT)

1. Bulk acoustic wave filter having at least two bulk acoustic wave resonators, with each bulk acoustic wave resonator having at least one first electrode (2;9), one piezo-electric layer (3, 10, 11) and one second electrode (1; 12, 13), with the first electrode (2; 9) being arranged on a substrate (4; 7)
**characterized in that**
at least two of the bulk acoustic wave resonators have effective resonator surfaces, which differ in the surface shape and/or surface content, the effective resonator surfaces which in each case results as the overlapping area when the two electrodes (15, 16) of one bulk acoustic wave resonator are projected onto one plane, of at least two of the bulk acoustic wave resonators having a nonrectangular shape.

2. Bulk acoustic wave filter according to Claim 1,
**characterized in that**
all the bulk acoustic wave resonators have effective resonator surfaces which differ in the surface shape and/or surface content.

3. Bulk acoustic wave filter according to Claim 1 or 2,
**characterized in that**
the effective resonator surfaces of at least two of the bulk acoustic wave resonators have a different aspect ratio.

4. Bulk acoustic wave filter according to Claim 3,
**characterized in that**
the effective resonator surfaces of all the bulk acoustic wave resonators have different aspect ratios.

5. Bulk acoustic wave filter according to Claim 1,
**characterized in that**
the effective resonator surfaces of all the bulk acoustic wave resonators have a nonrectangular shape.

6. Bulk acoustic wave filter according to one of Claims 3 to 5,
**characterized in that**
the aspect ratio of the effective resonator surfaces is between 1:1 and 1:5.

7. Bulk acoustic wave filter according to Claim 6,
**characterized in that**
the aspect ratio of the effective resonator surfaces is between 1:1.5 and 1:3.

8. Bulk acoustic wave filter according to one of the preceding claims,
**characterized in that**
the surface contents of effective resonator surfaces differ from one another by at least 5%, in particular by at least 10%.

9. Bulk acoustic wave filter according to Claim 8,
**characterized in that**
the surface contents of the effective resonator surfaces differ from one another by at least 20%, in particular by at least 50%.

10. Bulk acoustic wave filter according to one of the preceding claims,
**characterized in that**
the bulk acoustic wave resonators are connected in the form of a one and a half-stage conductor filter, in the form of a two-stage conductor filter, in the form of a two and a half-stage conductor filter, in the form of a three-stage conductor filter or in the form of a three and a half-stage conductor filter.

11. Bulk acoustic wave filter according to one of Claims 1 to 9,
**characterized in that**
the bulk acoustic wave resonators are connected in the form of a one-stage balanced filter, in the form of a two-stage balanced filter, or in the form of a three-stage balanced filter.

## Claims (Claims for the following Contracting State(s): DE, FR)

1. Bulk acoustic wave filter having at least two bulk acoustic wave resonators, with each bulk acoustic wave resonator having at least one first electrode (2;9), one piezo-electric layer (3, 10, 11) and one second electrode (1; 12, 13), the first electrode (2; 9) being arranged on a substrate (4; 7)
**characterized in that**
at least two of the bulk acoustic wave resonators have effective resonator surfaces, which differ in the surface shape and surface content, the effective resonator surfaces, which result in each case in the case of a projection of the two electrodes (15, 16) of a bulk acoustic wave resonator into a plane as the overlapping region of the electrodes, of at least two of the bulk acoustic wave resonators having a nonrectangular shape.

2. Bulk acoustic wave filter according to Claim 1,
**characterized in that**
all the bulk acoustic wave resonators have effective resonator surfaces which differ in the surface shape and/or surface content.

3. Bulk acoustic wave filter according to Claim 1 or 2,
**characterized in that**
the effective resonator surfaces of at least two of the bulk acoustic wave resonators have a different aspect ratio.

4. Bulk acoustic wave filter according to Claim 3,
**characterized in that**
the effective resonator surfaces of all the bulk acoustic wave resonators have different aspect ratios.

5. Bulk acoustic wave filter according to Claim 1,
**characterized in that**
the effective resonator surfaces of all the bulk acoustic wave resonators have a nonrectangular shape.

6. Bulk acoustic wave filter according to one of Claims 3 to 5,
**characterized in that**
the aspect ratio of the effective resonator surfaces is between 1:1 and 1:5.

7. Bulk acoustic wave filter according to Claim 6,
**characterized in that**
the aspect ratio of the effective resonator surfaces is between 1:1.5 and 1:3.

8. Bulk acoustic wave filter according to one of the preceding claims,
**characterized in that**
the surface contents of effective resonator surfaces differ from one another by at least 5%, in particular by at least 10%.

9. Bulk acoustic wave filter according to Claim 8,
**characterized in that**
the surface contents of the effective resonator surfaces differ from one another by at least 20%, in particular by at least 50%.

10. Bulk acoustic wave filter according to one of the preceding claims,
**characterized in that**
the bulk acoustic wave resonators are connected in the form of a one and a half-stage conductor filter, in the form of a two-stage conductor filter, in the form of a two and a half-stage conductor filter, in the form of a three-stage conductor filter or in the form of a three and a half-stage conductor filter.

11. Bulk acoustic wave filter according to one of Claims 1 to 9,
**characterized in that**
the bulk acoustic wave resonators are connected in the form of a one-stage balanced filter, in the form of a two-stage balanced filter, or in the form of a three-stage balanced filter

## Revendications (Revendications pour l'(les) Etat(s) contractant(s) suivant(s): IT)

1. Filtre d'onde acoustique en volume comprenant au moins deux résonateurs d'onde acoustique en volume chaque résonateur d'onde acoustique en volume comprenant au moins une première électrode (2 ; 9) une couche (3 ; 10 , 11) piézo-électrique et une deuxième électrode (1 ; 12 , 13), la première électrode (2 ; 9) étant disposée sur un substrat (4 ; 7)
**caractérisé en ce que**
au moins deux des résonateurs d'onde acoustique en volume ont des surfaces efficaces de résonateur qui se distinguent par la forme de la surface et/ ou par le contenu de la surface, les surfaces efficaces de résonateur qui se présentent respectivement, dans une projection des deux électrodes (15 ; 16) d'un résonateur d'onde acoustique en volume, dans un plan sous la forme de la partie à chevauchement des électrodes, d'au moins deux des résonateurs à onde acoustique en volume ayant une forme qui n'est pas à angle droit.

2. Filtre d'onde acoustique en volume suivant la revendication 1,
**caractérisé en ce que**,
tous les résonateurs d'onde acoustique en volume ont des surfaces efficaces de résonateur qui se distinguent par la forme de la surface et / ou le contenu de la surface.

3. Filtre d'onde acoustique en volume suivant la revendication 1 ou 2, **caractérisé en ce que** les surfaces efficaces de résonateur d'au moins deux des résonateurs d'onde acoustique en volume ont un rapport d'aspect différent.

4. Filtre d'onde acoustique en volume suivant la revendication 3, **caractérisé en ce** toutes les surfaces efficaces de résonateur de tous les résonateurs d'onde acoustique en volume ont des rapports d'aspect différents.

5. Filtre d'onde acoustique en volume suivant la revendication 1, **caractérisé en ce** les surfaces efficaces de résonateur de tous les résonateurs d'onde acoustique en volume ont une forme qui n'est pas à angle droit.

6. Filtre d'onde acoustique en volume suivant la revendication 3 à 5, **caractérisé en ce** le rapport d'aspect des surfaces efficaces de résonateur est compris entre 1 : 1 et 1 : 5.

7. Filtre d'onde acoustique en volume suivant la revendication 6, **caractérisé en ce** le rapport d'aspect des surfaces efficaces de résonateur est compris entre 1 : 1,5 et 1 : 3.

8. Filtre d'onde acoustique en volume suivant l'une des revendications précédentes, **caractérisé en ce que** les contenus des surfaces efficaces de résonateur se distinguent entre eux d'au moins 5 %, notamment d'au moins 10 %.

9. Filtre d'onde acoustique en volume suivant la revendication 8, **caractérisé en ce que** les contenus des surfaces efficaces de résonateur se distinguent entre eux d'au moins 20 %, notamment d'au moins 50 %.

10. Filtre d'onde acoustique en volume suivant les revendications précédentes, **caractérisé en ce que** les résonateurs d'onde acoustique en volume sont câblés sous la forme d'un filtre à conducteur à 1 étage ½, sous la forme d'un filtre à conducteur à deux étages, sous la forme d'un filtre à conducteur à 2 étages ½, sous la forme d'un filtre à conducteur à 3 étages ou sous la forme d'un filtre à conducteur à 3 étages ½.

11. Filtre d'onde acoustique en volume suivant les revendications 1 à 9, **caractérisé en ce que** les résonateurs d'onde acoustique en volume sont câblés sous la forme de filtres équilibrés à 1 étage, sous la forme de filtres équilibrés à 2 étages ou sous la forme de filtres équilibrés à 3 étages.

## Revendications (Revendications pour l'(les) Etat(s) contractant(s) suivant(s): DE, FR)

1. Filtre d'onde acoustique en volume comprenant au moins deux résonateurs d'onde acoustique en volume chaque résonateur d'onde acoustique en volume comprenant au moins une première électrode (2 ; 9) une couche (3 ; 10 , 11) piézo-électrique et une deuxième électrode (1 ; 12 , 13), la première électrode (2 ; 9) étant disposée sur un substrat (4 ; 7)
**caractérisé en ce que**
au moins deux des résonateurs d'onde acoustique en volume ont des surfaces efficaces de résonateur qui se distinguent par la forme de la surface et par le contenu de la surface, les surfaces efficaces de résonateur qui se présentent respectivement, dans une projection des deux électrodes (15 ; 16) d'un résonateur d'onde acoustique en volume, dans un plan sous la forme de la partie à chevauchement des électrodes, d'au moins deux des résonateurs à onde acoustique en volume ayant une forme qui n'est pas à angle droit.

2. Filtre d'onde acoustique en volume suivant la revendication 1,
**caractérisé en ce que**,
tous les résonateurs d'onde acoustique en volume ont des surfaces efficaces de résonateur qui se distinguent par la forme de la surface et / ou le contenu de la surface.

3. Filtre d'onde acoustique en volume suivant la revendication 1 ou 2, **caractérisé en ce que** les surfaces efficaces de résonateur d'au moins deux des résonateurs d'onde acoustique en volume ont un rapport d'aspect différent.

4. Filtre d'onde acoustique en volume suivant la revendication 3, **caractérisé en ce** toutes les surfaces efficaces de résonateur de tous les résonateurs d'onde acoustique en volume ont des rapports d'aspect différents.

5. Filtre d'onde acoustique en volume suivant la revendication 1, **caractérisé en ce** les surfaces efficaces de résonateur de tous les résonateurs d'onde acoustique en volume ont une forme qui n'est pas à angle droit.

6. Filtre d'onde acoustique en volume suivant la revendication 3 à 5, **caractérisé en ce** le rapport d'aspect des surfaces efficaces de résonateur est compris entre 1 : 1 et 1 : 5.

7. Filtre d'onde acoustique en volume suivant la revendication 6, **caractérisé en ce** le rapport d'aspect des surfaces efficaces de résonateur est compris entre 1 : 1,5 et 1 : 3.

8. Filtre d'onde acoustique en volume suivant l'une des revendications précédentes, **caractérisé en ce que** les contenus des surfaces efficaces de résonateur se distinguent entre eux d'au moins 5 %, notamment d'au moins 10 %.

9. Filtre d'onde acoustique en volume suivant la revendication 8, **caractérisé en ce que** les contenus des surfaces efficaces de résonateur se distinguent entre eux d'au moins 20 %, notamment d'au moins 50 %.

10. Filtre d'onde acoustique en volume suivant les revendications précédentes, **caractérisé en ce que** les résonateurs d'onde acoustique en volume sont câblés sous la forme d'un filtre à conducteur à 1 étage ½, sous la forme d'un filtre à conducteur à deux étages, sous la forme d'un filtre à conducteur à 2 étages ½, sous la forme d'un filtre à conducteur à 3 étages ou sous la forme d'un filtre à conducteur à 3 étages ½.

11. Filtre d'onde acoustique en volume suivant les revendications 1 à 9, **caractérisé en ce que** les résonateurs d'onde acoustique en volume sont câblés sous la forme de filtres équilibrés à 1 étage, sous la forme de filtres équilibrés à 2 étages ou sous la forme de filtres équilibrés à 3 étages.
